# EUROPEAN PATENT SPECIFICATION

(11) **EP 4 403 938 B1**
(45) Date of publication and mention of the grant of the patent: **30.07.2025**
(21) Application number: 23215518.4
(22) Date of filing: 11.12.2023
(51) Int. Cl.: G01R 31/327, H01H 47/00

(54) **RELAY ADHESION DETECTION CIRCUIT**
RELAISKONTAKT-HAFTUNGSDETEKTIONSSCHALTUNG
CIRCUIT DE DÉTECTION D'ADHÉRENCE DE CONTACT DE RELAIS

(30) Priority: 19.01.2023 CN 202310101046
(43) Date of publication of application: 24.07.2024
(73) Proprietor: Huawei Digital Power Technologies Co., Ltd., Shenzhen, 518043 (CN)
(72) Inventor: LI, Zhibin, Shenzhen, 518043 (CN); FAN, Xiaobin, Shenzhen, 518043 (CN); GUO, Long, Shenzhen, 518043 (CN); LUO, Haisong, Shenzhen, 518043 (CN); YANG, Bingyuan, Shenzhen, 518043 (CN)
(74) Representative: Epping - Hermann - Fischer

(56) References cited:
- CN-A- 108 051 733
- CN-A- 112 557 893
- CN-A- 112 858 895

## Description

### TECHNICAL FIELD

This application relates to the field of circuit technologies, and in particular, to a relay adhesion detection circuit and a power adapter.

### BACKGROUND

When an alternating current power grid serves as an alternating current source to supply power to a converter, the alternating current power grid is connected to the converter by using a zero wire and a live wire, relays are disposed in both the zero wire and the live wire, and connection and disconnection of the zero wire and the live wire are controlled by using the relays. A relay is a switch apparatus, and can meet a specific insulation distance after being disconnected. Although a contact in the relay has specific tolerance to an overcurrent, when a special case occurs, the contact may be adhered, thereby affecting electrical safety. Therefore, in view of safety and reliability, relay adhesion needs to be detected. However, in a current adhesion detection solution, adhesion detection is generally implemented by adding an auxiliary contact to a relay. Although this type of solution can achieve an objective of adhesion detection, a manufacturing cost and a volume that are of the relay are increased.

CN 108051733 A relates to a relay adhesion detection system and method for multi-cell cluster. Hereby, the system comprises a main control unit and a plurality of battery control units. A battery control unit includes a battery pack, three relays and a pre-charging resistor.

CN 112557893 A relates to a relay adhesion detection circuit, method and battery management system. The relay adhesion detection circuit includes two terminals, a battery, a load, as well as two control switches.

CN 112858895 A relates to a DC charging pile DC relay adhesion judgment method and its circuit. The DC charging pile DC relay adhesion judgment circuit includes a voltage sampling circuit. The voltage sampling circuit includes a sampling resistor, an operational amplifier circuit and a transient diode unit.

### SUMMARY

This application provides a relay adhesion detection circuit, to detect whether a relay is adhered, and avoid increasing a manufacturing cost and a volume that are of the relay.

According to a first aspect, an embodiment of this application provides a detection circuit. In two lines between a power supply and a load, when a first relay is disposed in one of the lines, and a second relay is disposed in the other line, the detection circuit includes two detection branches. If a connection end that is of the first relay and that is directly connected to the power supply is denoted as a first node, a connection end that is of the first relay and that is directly connected to the load is denoted as a second node, a connection end that is of the second relay and that is directly connected to the power supply is denoted as a third node, and a connection end that is of the second relay and that is directly connected to the load is denoted as a fourth node, one detection branch (which is referred to as a first detection branch) is separately connected to the first node, the second node, and the third node, and the other detection branch (which is referred to as a second detection branch) is separately connected to the third node, the fourth node, and the first node.

When the first relay and the second relay are both disconnected, and the power supply outputs a signal, a current flows through the first detection branch and the second detection branch. In this case, the first detection branch detects a voltage between the first node and the second node, or detect a voltage between the second node and the third node, or detect a voltage between the first node and the second node and a voltage between the second node and the third node. The second detection branch detects a voltage between the third node and the fourth node, or detect a voltage between the first node and the fourth node, or detect a voltage between the third node and the fourth node and a voltage between the first node and the fourth node. Therefore, each detection branch detects at least one of a voltage between two connection ends of a corresponding relay and a voltage between one connection end of the first relay and the other connection end of the second relay, where in the one connection end of the first relay and the other connection end of the second relay, one is directly connected to the power supply, and the other is directly connected to the load. Based on this, when an output voltage of the power supply is determined, whether the first relay is adhered is determined by comparing a voltage detected by the first detection branch with the output voltage, and whether the second relay is adhered is determined by comparing a voltage detected by the second detection branch with the output voltage, thereby detecting an adhesion status of each relay. In addition, in this application, whether each relay is adhered is detected by using the detection circuit, and a structure of the relay does not need to be changed, so that increases in a manufacturing cost and a volume that are of the relay may be avoided, thereby implementing adhesion detection on a basis of keeping an original structure unchanged.

In addition, during voltage detection, detection may be performed based on a specified collection cycle, or detection may be triggered at any time based on a requirement. Because voltage detection is not limited by a power-off sequence and a power-off interval of the two relay s, detection efficiency may be improved, thereby improving relay determining efficiency.

In some embodiments, the first detection branch includes a first impedance unit, a second impedance unit, and a first voltage collection unit. The first impedance unit is separately connected to the first node and the second node, and the second impedance unit is separately connected to the second node and the third node.

When the first detection branch is configured to detect the voltage between the first node and the second node, and does not need to detect the voltage between the second node and the third node, one first voltage collection unit may be disposed, and the first voltage collection unit is connected to the first impedance unit. Alternatively, when the first detection branch is configured to detect the voltage between the second node and the third node, and does not need to detect the voltage between the first node and the second node, one first voltage collection unit may also be disposed, and the first voltage collection unit is connected to the second impedance unit. Alternatively, when the first detection branch is configured to detect both the voltage between the first node and the second node and the voltage between the second node and the third node, two first voltage collection units may be disposed, one of the first voltage collection units is connected to the first impedance unit, and the other first voltage collection unit is connected to the second impedance unit.

In this way, when the first relay is adhered, the first node and the second node are short-circuited, so that potentials of the first node and the second node are the same or approximately the same. Therefore, a current does not pass through the first impedance unit, but directly flows from the first node to the second node. If the first voltage collection unit is connected to the first impedance unit, a voltage collected in this case is zero, or is close to zero, or is a value that is very small compared with the output voltage. In this case, it may be determined that the first relay is adhered. If the first voltage collection unit is connected to the second impedance unit, because the second impedance unit is separately connected to the second node and the third node, and the potentials of the second node and the first node are almost the same, a voltage collected by the first voltage collection unit is close to the output voltage of the power supply. In this case, the voltage collected by the first voltage collection unit is compared with the output voltage. If the collected voltage is very close to the output voltage, it may be determined that the first relay is adhered.

When the first relay is normally disconnected, the first node and the second node are completely disconnected. Therefore, impedance between the first node and the second node is very large, and a current passes through the first impedance unit. If the first voltage collection unit is connected to the first impedance unit, a voltage collected in this case is a voltage drop generated by the first impedance unit. If the first voltage collection unit is connected to the second impedance unit, a voltage collected in this case is a voltage drop generated by the second impedance unit. In this case, it may be determined, by comparing the collected voltage with the output voltage, that the first relay is normally disconnected.

In some embodiments, the second detection branch includes a third impedance unit, a fourth impedance unit, and a second voltage collection unit. The third impedance unit is separately connected to the third node and the fourth node, and the fourth impedance unit is separately connected to the fourth node and the first node.

When the second detection branch is configured to detect the voltage between the third node and the fourth node, and does not need to detect the voltage between the fourth node and the first node, one second voltage collection unit may be disposed, and the second voltage collection unit is connected to the third impedance unit. Alternatively, when the second detection branch is configured to detect the voltage between the fourth node and the first node, and does not need to detect the voltage between the third node and the fourth node, one second voltage collection unit may be disposed, and the second voltage collection unit is connected to the fourth impedance unit. Alternatively, when the second detection branch is configured to detect both the voltage between the third node and the fourth node and the voltage between the fourth node and the first node, two second voltage collection units are disposed, one of the second voltage collection units is connected to the third impedance unit, and the other second voltage collection unit is connected to the fourth impedance unit.

In this way, when the second relay is adhered, the third node and the fourth node are short-circuited, so that potentials of the third node and the fourth node are the same or approximately the same. Therefore, a current does not pass through the third impedance unit, but directly flows from the fourth node to the third node. If the second voltage collection unit is connected to the third impedance unit, a voltage collected in this case is zero, or is close to zero, or is a value that is very small compared with the output voltage. In this case, it may be determined that the second relay is adhered. If the second voltage collection unit is connected to the fourth impedance unit, because the fourth impedance unit is separately connected to the first node and the fourth node, and the potentials of the fourth node and the third node are almost the same, a voltage collected by the second voltage collection unit is close to the output voltage of the power supply. In this case, the voltage collected by the second voltage collection unit is compared with the output voltage. If the collected voltage is very close to the output voltage, it may be determined that the second relay is adhered.

When the second relay is normally disconnected, the third node and the fourth node are completely disconnected. Therefore, impedance between the third node and the fourth node is very large, and a current passes through the third impedance unit. If the second voltage collection unit is connected to the third impedance unit, a voltage collected in this case is a voltage drop generated by the third impedance unit. If the second voltage collection unit is connected to the fourth impedance unit, a voltage collected in this case is a voltage drop generated by the fourth impedance unit. In this case, it may be determined that the second relay is normally disconnected.

In some embodiments, a filter capacitor is generally disposed between the two lines, and the filter capacitor has a characteristic of allowing an alternating current to pass through and blocking a direct current. Therefore, when the power supply outputs an alternating current signal, the alternating current signal may pass through the filter capacitor, and an impedance value of the filter capacitor is generally not large, or an impedance value of the filter capacitor is generally much less than impedance values of the first impedance unit, the second impedance unit, the third impedance unit, and the fourth impedance unit. When the power supply outputs a direct current signal, the filter capacitor may be considered as very large impedance, and the direct current signal generally does not pass through the filter capacitor. Therefore, when a type of a signal output by the power supply is different, there is a difference in performing adhesion determining based on voltages collected by the first voltage collection unit and the second voltage collection unit. Details are as follows:
That the first voltage collection unit is connected to the second impedance unit, and the second voltage collection unit is connected to the third impedance unit is used as an example.

### 1. The power supply outputs an alternating current signal.

### 1.1. The first relay is normally disconnected, and the second relay is adhered.

If the first relay is normally disconnected, and the second relay is adhered, because the filter capacitor and the second impedance unit are disposed in parallel, and the impedance value of the filter capacitor is much less than an impedance value of the second impedance unit, the alternating current signal returns to the power supply through the filter capacitor after passing through the first impedance unit, and few alternating current signals flow through the second impedance unit, so that a current flowing through the second impedance unit is relatively small and is close to zero. Therefore, a divided voltage that is of the second impedance unit and that is collected by the first voltage collection unit is very small compared with the output voltage or is close to zero. When the second voltage collection unit is connected to the third impedance unit, because the second relay is adhered, a collected voltage is also very small compared with the output voltage or is close to zero. Therefore, when the voltages collected by the first voltage collection unit and the second voltage collection unit are both very small compared with the output voltage or are both close to zero, it may be determined that the first relay is normally disconnected, and the second relay is adhered.

### 1.2. The first relay is adhered, and the second relay is normally disconnected.

If the first relay is adhered, and the second relay is normally disconnected, because the second impedance unit is separately connected to the second node and the third node, when the potentials of the first node and the second node are the same, a divided voltage of the second impedance unit is a voltage between the first node and the third node. In addition, because the voltage between the first node and the third node is the output voltage, the divided voltage of the second impedance unit is the output voltage. When the first voltage collection unit is connected to the second impedance unit, a collected voltage is close to the output voltage. Because the first relay is adhered, the fourth impedance unit and the filter capacitor are in a parallel connection relationship. When the impedance value of the filter capacitor is much less than an impedance value of the fourth impedance unit, a current flowing through the fourth impedance unit is very small. In this case, it is temporarily considered that the current flowing through the fourth impedance unit is zero, and therefore, it is temporarily considered that a divided voltage of the fourth impedance unit is zero. When the second relay is normally disconnected, the power supply, the filter capacitor, and the third impedance unit may form a current loop. When the impedance value of the filter capacitor is much less than the impedance value of the fourth impedance unit, a divided voltage of the third impedance unit is close to the output voltage. Therefore, when the second voltage collection unit is connected to the third impedance unit, a collected voltage is close to the output voltage. Therefore, when the voltages collected by the first voltage collection unit and the second voltage collection unit are both close to the output voltage, it may be determined that the first relay is adhered, and the second relay is normally disconnected.

### 1.3. The first relay is adhered, and the second relay is adhered.

If the first relay is adhered, and the second relay is adhered, similarly, if the voltage collected by the first voltage collection unit is close to the output voltage, and the voltage collected by the second voltage collection unit is very small compared with the output voltage or is close to zero, it may be determined that the first relay is adhered, and the second relay is adhered.

### 1.4. The first relay is normally disconnected, and the second relay is normally disconnected.

If the first relay is normally disconnected, and the second relay is normally disconnected, the alternating current signal separately passes through the first detection branch and the second detection branch. Therefore, when the first voltage collection unit is connected to the second impedance unit, a collected voltage is a divided voltage that is of the second impedance unit and that is obtained through voltage division between the first impedance unit and the second impedance unit. When impedance of the first impedance unit is represented by R1, impedance of the second impedance unit is represented by R2, and the output voltage is represented by Vs, the collected voltage is close to R2*Vs/(R1+R2). When the second voltage collection unit is connected to the third impedance unit, a collected voltage is a divided voltage that is of the third impedance unit and that is obtained through voltage division between the third impedance unit and the fourth impedance unit. When impedance of the third impedance unit is represented by R3, and impedance of the fourth impedance unit is represented by R4, the collected voltage is close to R3*Vs/(R3+R4). Therefore, when the voltage collected by the first voltage collection unit is close to R2*Vs/(R1+R2), and the voltage collected by the second voltage collection unit is close to R3*Vs/(R3+R4), it may be determined that the first relay is normally disconnected, and the second relay is normally disconnected.

### 2. The power supply outputs a direct current signal.

### 2.1. The first relay is normally disconnected, and the second relay is adhered.

If the first relay is normally disconnected, and the second relay is adhered, although the filter capacitor and the second impedance unit are disposed in parallel, because the impedance value of the filter capacitor is much greater than an impedance value of the second impedance unit, the direct current signal returns to the power supply through the second impedance unit after passing through the first impedance unit. Therefore, the voltage collected by the first voltage collection unit is a divided voltage that is of the second impedance unit and that is obtained through voltage division between the first impedance unit and the second impedance unit. When impedance of the first impedance unit is represented by R1, impedance of the second impedance unit is represented by R2, and the output voltage is represented by Vs, the collected voltage is close to R2*Vs/(R1+R2). When the second voltage collection unit is connected to the third impedance unit, because the second relay is adhered, a collected voltage is very small compared with the output voltage or is close to zero. Therefore, when the voltage collected by the first voltage collection unit is close to R2*Vs/(R1+R2), and the voltage collected by the second voltage collection unit is very small compared with the output voltage or is close to zero, it may be determined that the first relay is normally disconnected, and the second relay is adhered.

### 2.2. The first relay is adhered, and the second relay is normally disconnected.

If the first relay is adhered, and the second relay is normally disconnected, because the second impedance unit is separately connected to the second node and the third node, when the potentials of the first node and the second node are the same, a divided voltage of the second impedance unit is a voltage between the first node and the third node. In addition, because the voltage between the first node and the third node is the output voltage, the divided voltage of the second impedance unit is the output voltage. When the first voltage collection unit is connected to the second impedance unit, a collected voltage is close to the output voltage. Because the first relay is adhered, the fourth impedance unit and the filter capacitor are in a parallel connection relationship. When the impedance value of the filter capacitor is much greater than an impedance value of the fourth impedance unit, a current flowing through the filter capacitor is very small and close to zero. Therefore, the fourth impedance unit, the third impedance unit, and the power supply may form a current loop. When the second voltage collection unit is connected to the third impedance unit, a collected voltage is close to a divided voltage that is of the third impedance unit and that is obtained through voltage division between the third impedance unit and the fourth impedance unit. When impedance of the third impedance unit is represented by R3, and impedance of the fourth impedance unit is represented by R4, the collected voltage is close to R3*Vs/(R3+R4). Therefore, when the voltage collected by the first voltage collection unit is close to the output voltage, and the voltage collected by the second voltage collection unit is close to R3*Vs/(R3+R4), it may be determined that the first relay is adhered, and the second relay is normally disconnected.

### 2.3. The first relay is adhered, and the second relay is adhered.

If the first relay is adhered, and the second relay is adhered, similarly, if the voltage collected by the first voltage collection unit is close to the output voltage, and the voltage collected by the second voltage collection unit is very small compared with the output voltage or is close to zero, it may be determined that the first relay is adhered, and the second relay is adhered.

### 2.4. The first relay is normally disconnected, and the second relay is normally disconnected.

If the first relay is normally disconnected, and the second relay is normally disconnected, similarly, when the first voltage collection unit is connected to the second impedance unit, a collected voltage is a divided voltage that is of the second impedance unit and that is obtained through voltage division between the first impedance unit and the second impedance unit, that is, R2*Vs/(R1+R2). When the second voltage collection unit is connected to the third impedance unit, a collected voltage is close to a divided voltage that is of the third impedance unit and that is obtained through voltage division between the third impedance unit and the fourth impedance unit, that is, R3*Vs/(R3+R4). Therefore, when the voltage collected by the first voltage collection unit is close to R2*Vs/(R1+R2), and the voltage collected by the second voltage collection unit is close to R3*Vs/(R3+R4), it may be determined that the first relay is normally disconnected, and the second relay is normally disconnected.

Therefore, the detection circuit provided in this embodiment of this application may be applied not only to an alternating current scenario, but also to a direct current scenario. In addition, especially in a scenario in which input frequently fluctuates, the detection circuit may adjust potentials of contacts of the two relays to ground, so that the two relays are not affected by a Y capacitor, thereby ensuring normal working of the two relays.

In some embodiments, the impedance values of the first impedance unit, the second impedance unit, the third impedance unit, and the fourth impedance unit may all be set to be the same. In this case, it may be directly determined whether the voltages collected by the first voltage collection unit and the second voltage collection unit are close to zero, the output voltage, or half of the output voltage. In this way, a calculation amount and an arithmetic operation amount may be reduced, and determining efficiency may be improved. Certainly, the impedance values of the first impedance unit, the second impedance unit, the third impedance unit, and the fourth impedance unit may alternatively be set to be at least partially different. In this case, the impedance values of the impedance units may be adjusted based on actual requirements to meet requirements of different application scenarios, thereby improving design flexibility. In some embodiments, when the power supply is configured to output an alternating current signal, at least one of the first impedance unit, the second impedance unit, the third impedance unit, and the fourth impedance unit may include at least one of an inductor, a resistor, and a capacitor. When the power supply is configured to output a direct current signal, at least one of the first impedance unit, the second impedance unit, the third impedance unit, and the fourth impedance unit may include at least one of a resistor and a capacitor. In this way, structures of the impedance units may be set for different application scenarios, so that design flexibility may be improved.

In addition, the structures of the first impedance unit, the second impedance unit, the third impedance unit, and the fourth impedance unit may all be set to be the same, to simplify a structure of the detection circuit, and reduce manufacturing difficulty and a manufacturing cost that are of the detection circuit. Certainly, the structures of the first impedance unit, the second impedance unit, the third impedance unit, and the fourth impedance unit may alternatively be set to be at least partially different, so that requirements of different application scenarios may be met, and design flexibility may be improved.

In some embodiments, the output voltage of the power supply may be obtained from a supplier of the power supply, or a third voltage collection unit connected between the two lines may be disposed, and the output voltage is collected by using the third voltage collection unit. In addition, structures of the first voltage collection unit, the second voltage collection unit, and the third voltage collection unit may all be set to be the same, to simplify the structure of the detection circuit, and reduce the manufacturing difficulty and the manufacturing cost that are of the detection circuit. Certainly, the structures of the first voltage collection unit, the second voltage collection unit, and the third voltage collection unit may alternatively be set to be at least partially different, so that requirements of different application scenarios may be met, and design flexibility may be improved. It should be understood that, when the third voltage collection unit is not disposed, structures of the first voltage collection unit and the second voltage collection unit may be set to be the same or different.

In some embodiments, when the first voltage collection unit is connected to the first impedance unit, the first impedance unit may be a part of the first voltage collection unit, that is, the first impedance unit and the first voltage collection unit belong to a same independent component; or when the first voltage collection unit is connected to the second impedance unit, the second impedance unit may be a part of the first voltage collection unit, that is, the second impedance unit and the first voltage collection unit belong to a same independent component. Similarly, when the second voltage collection unit is connected to the third impedance unit, the third impedance unit may be a part of the second voltage collection unit, that is, the third impedance unit and the second voltage collection unit belong to a same independent component; or when the second voltage collection unit is connected to the fourth impedance unit, the fourth impedance unit may be a part of the second voltage collection unit, that is, the fourth impedance unit and the second voltage collection unit belong to a same independent component.

In some embodiments, specific structures of the first voltage collection unit, the second voltage collection unit, and the third voltage collection unit are not limited herein. Any structure that can implement voltage collection falls within the protection scope of this embodiment of this application.

According to a second aspect, an example useful for understanding the invention further provides a power adapter, including a first relay, a second relay, a detection circuit, a converter, and a processor. In two lines connected to the converter, the first relay is disposed in one of the lines, and the second relay is disposed in the other line. The detection circuit is separately connected to a first connection end and a second connection end of the first relay, a first connection end and a second connection end of the second relay, and the processor. The detection circuit may be configured to: when the first relay and the second relay are both disconnected, and a current passes through the two lines and the detection circuit, detect at least one of a voltage between the two connection ends of the first relay and a voltage between the first connection end of the first relay and the second connection end of the second relay, detect at least one of a voltage between the two connection ends of the second relay and a voltage between the first connection end of the second relay and the second end of the first relay, and transmit a detected voltage to the processor. The processor may be configured to determine, based on the voltage detected by the detection circuit and a voltage between the two lines, whether the first relay and the second relay are adhered.

When the first connection end of the first relay and the first connection end of the second relay are both located on a side facing the converter, the second connection end of the first relay and the second connection end of the second relay are both located on a side away from the converter; or when the first connection end of the first relay and the first connection end of the second relay are both located on a side away from the converter, the second connection end of the first relay and the second connection end of the second relay are both located on a side facing the converter. In this way, whether each relay is adhered may be determined by comparing the voltage detected by the detection circuit with the voltage between the two lines. In this adhesion detection manner, a structure of a relay does not need to be changed, so that increases in a manufacturing cost and a volume that are of the relay may be avoided, thereby implementing adhesion detection on a basis of keeping an original structure unchanged. In addition, during voltage detection, detection may be performed based on a specified collection cycle, or detection may be triggered at any time based on a requirement. Because voltage detection is not limited by a power-off sequence and a power-off interval of the two relays, detection efficiency may be improved, thereby improving relay determining efficiency.

A specific implementation principle of the detection circuit in the power adapter is similar to an implementation principle of the foregoing detection circuit. For a specific implementation of the detection circuit in the power adapter, refer to the specific embodiment of the foregoing detection circuit. No repeated description is provided.

In some examples useful for understanding the invention, when the power adapter is disposed between a power supply and a load, the converter is separately connected to the power supply and the load. In this case, the converter may perform voltage conversion processing and power conversion processing on a signal output by the power supply, and then transmit the signal to the load, so that the load uses the signal and is driven to work. The power supply may be an alternating current source configured to provide an alternating current signal, or a direct current source configured to provide a direct current signal. The alternating current source may be but is not limited to an alternating current power grid, an alternating current charging pile, or the like. The direct current source may be but is not limited to a photovoltaic power supply, a direct current charging pile, or the like. In addition, if the first relay and the second relay are respectively disposed in two lines between the converter and the power supply, the detection circuit may be separately connected to the two lines between the converter and the power supply. In this case, a voltage between the two lines may be considered as an output voltage of the power supply. If the first relay and the second relay are respectively disposed in two lines between the converter and the load, the detection circuit may be separately connected to the two lines between the converter and the load. In this case, a voltage between the two lines may be considered as an output voltage of the converter.

In some examples useful for understanding the invention, when the detection circuit includes two detection branches, each detection branch can detect a voltage. One of the detection branches is configured to detect the at least one of the voltage between the first connection end of the first relay and the second connection end of the first relay and the voltage between the first connection end of the first relay and the second connection end of the second relay, and the other detection branch is configured to detect the at least one of the voltage between the first connection end of the second relay and the second connection end of the second relay and the voltage between the first connection end of the second relay and the second connection end of the first relay. In this case, the processor may further calculate a difference between voltages respectively detected by the two detection branches, and redetermine, based on the difference and the voltage between the two lines, whether the first relay and the second relay are adhered. In this way, further determining may be performed on whether there is adhesion, thereby improving accuracy of a determining result.

### BRIEF DESCRIPTION OF DRAWINGS

FIG. 1 is a schematic diagram of a structure of an electricity consumption scenario according to an embodiment of this application;
FIG. 2 is a schematic diagram of a structure of a detection circuit according to an embodiment of this application;
FIG. 3 is a schematic diagram of a structure of another detection circuit according to an embodiment of this application;
FIG. 4 is a flowchart of a detection method according to an embodiment of this application;
FIG. 5 is a schematic diagram of a structure of a power adapter according to an example; and
FIG. 6 is a schematic diagram of a structure of another power adapter according to an example.

### Reference numerals:

m1: power supply; m2: load; m3: power adapter; k0: relay; k1: first relay; k2: second relay; L: zero wire; N: live wire; x+: positive bus; x-: negative bus; 100: detection circuit; 10: first detection branch; 11: first impedance unit; 12: second impedance unit; 13: first voltage collection unit; 20: second detection branch; 21: third impedance unit; 22: fourth impedance unit; 23: second voltage collection unit; 30: third voltage collection unit; 200: processor; 300: converter.

### DESCRIPTION OF EMBODIMENTS

To make the objectives, technical solutions, and advantages of this application clearer, the following further describes this application in detail with reference to accompanying drawings.

It should be noted that same reference numerals in the accompanying drawings of this application represent same or similar structures, and therefore repeated descriptions of the same reference numerals are omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

An application scenario of this application is first described.

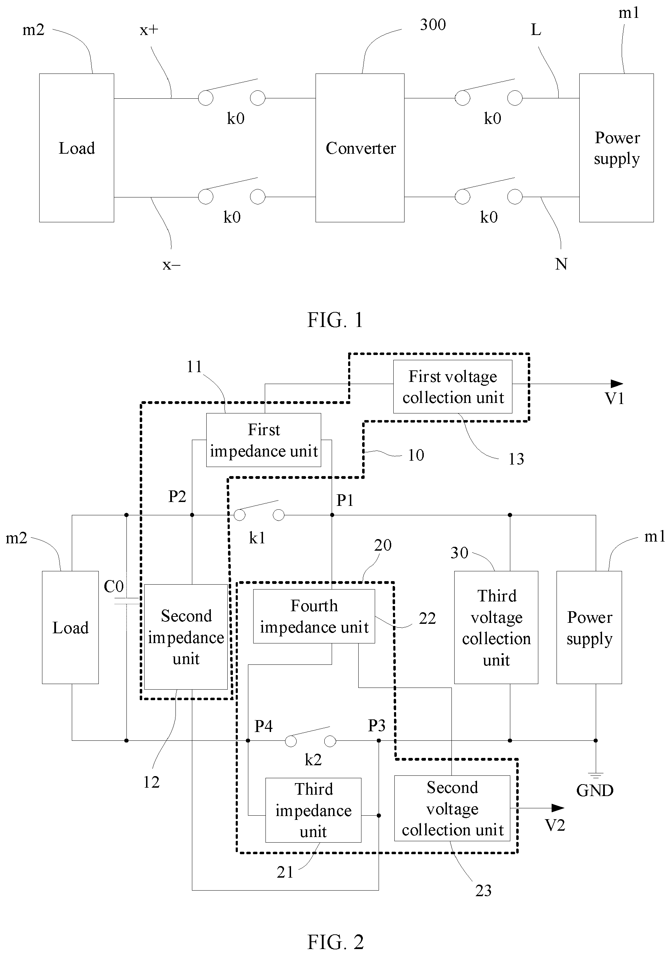

In a schematic diagram of an electricity consumption scenario shown in FIG. 1, when a power supply m1 is an alternating current source, the power supply m1 may be connected to a converter 300 by using a zero wire L and a live wire N, and the converter 300 may be connected to a load m2 by using a positive bus x+ and a negative bus x-. The converter 300 is configured to perform voltage conversion and power conversion on an alternating current signal provided by the alternating current source, to obtain a direct current signal for driving the load m2. Certainly, the power supply m1 may alternatively be a direct current source. In this case, the power supply m1 is connected to the converter 300 by using the positive bus and the negative bus. It should be understood that the zero wire L, the live wire N, the positive bus x+, and the negative bus x- may be collectively referred to as two lines.

Relays k0 are disposed in the zero wire L, the live wire N, the positive bus x+, and the negative bus x-. When relays k0 in the zero wire L and the live wire N are both disconnected, if at least one of the two relays k0 is adhered, the power supply m1 cannot be effectively disconnected from the converter 300. When relays k0 in the positive bus x+ and the negative bus x- are both disconnected, if at least one of the two relays k0 is adhered, the converter 300 cannot be effectively disconnected from the load m2, thereby affecting electrical safety. Therefore, in view of safety and reliability, relay adhesion needs to be detected. However, in a current adhesion detection solution, adhesion detection is generally implemented by adding an auxiliary contact to a relay. Although this type of solution can achieve an objective of adhesion detection, a manufacturing cost and a volume that are of the relay are increased.

An embodiment of this application provides a detection circuit. The detection circuit may be disposed between a power supply and a converter, to detect whether two relays between the power supply and the converter are adhered. Certainly, the detection circuit may be further disposed between the converter and a load, to detect whether two relays between the converter and the load are adhered. In this adhesion detection manner, a structure of a relay does not need to be changed, so that increases in a manufacturing cost and a volume that are of the relay may be avoided, thereby implementing adhesion detection on a basis of keeping an original structure unchanged.

The following describes the detection circuit in detail.

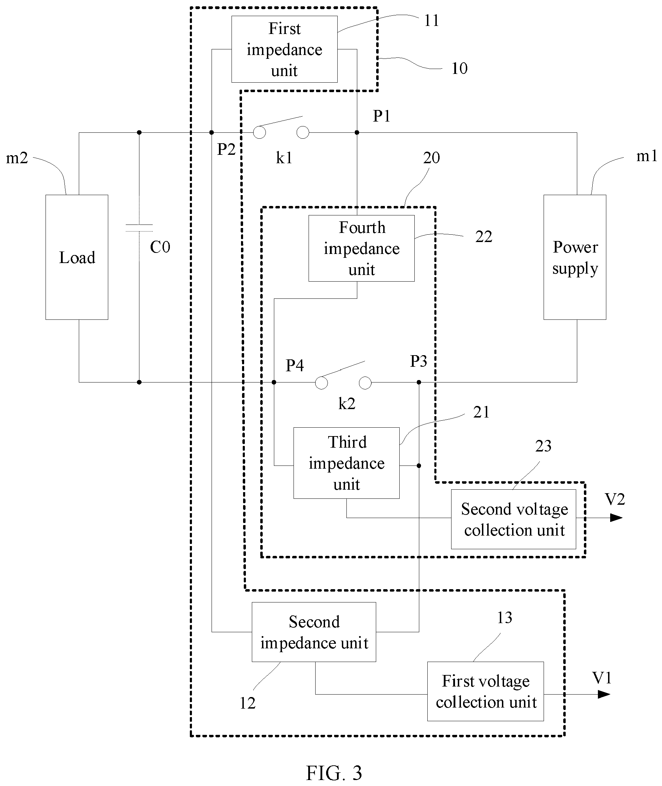

The solution of this application may be applied to schematic diagrams of structures of detection circuits shown in FIG. 2 and FIG. 3. As shown in FIG. 2 and FIG. 3, in two lines between a power supply m1 and a load m2, a first relay (denoted as k1) is disposed in one of the lines, and a second relay (denoted as k2) is disposed in the other line. A connection end that is of the first relay k1 and that is directly connected to the power supply m1 is denoted as a first node P1, a connection end that is of the first relay k1 and that is directly connected to the load m2 is denoted as a second node P2, a connection end that is of the second relay k2 and that is directly connected to the power supply m1 is denoted as a third node P3, and a connection end that is of the second relay k2 and that is directly connected to the load m2 is denoted as a fourth node P4. One detection branch (which may be referred to as a first detection branch) 10 in a detection circuit 100 is separately connected to the first node P1, the second node P2, and the third node P3, and another detection branch (which may be referred to as a second circuit detection branch) 20 in the detection circuit 100 is separately connected to the third node P3, the fourth node P4, and the first node P1.

When the first relay k1 and the second relay k2 are both disconnected, and the power supply m1 outputs a signal, a current may flow through the first detection branch 10 and the second detection branch 20. In this case, the first detection branch 10 may detect a voltage between the first node P1 and the second node P2, or detect a voltage between the second node P2 and the third node P3 (that is, detect a voltage between the two lines), or detect a voltage between the first node P1 and the second node P2 and a voltage between the second node P2 and the third node P3. The second detection branch 20 may detect a voltage between the third node P3 and the fourth node P4, or detect a voltage between the first node P1 and the fourth node P4 (that is, detect the voltage between the two lines), or detect a voltage between the third node P3 and the fourth node P4 and a voltage between the first node P1 and the fourth node P4.

Based on this, when an output voltage of the power supply m1 is determined, whether the first relay k1 is adhered may be determined by comparing a voltage detected by the first detection branch 10 with the output voltage, and whether the second relay k2 is adhered may be determined by comparing a voltage detected by the second detection branch 20 with the output voltage, thereby detecting an adhesion status of each relay. In addition, in this application, whether each relay is adhered may be detected by using the detection circuit, and a structure of the relay does not need to be changed, so that increases in a manufacturing cost and a volume that are of the relay may be avoided, thereby implementing adhesion detection on a basis of keeping an original structure unchanged. In addition, during voltage detection, detection may be performed based on a specified collection cycle, or detection may be triggered at any time based on a requirement. Because voltage detection is not limited by a power-off sequence and a power-off interval of the two relays, detection efficiency may be improved, thereby improving relay determining efficiency.

In some embodiments, as shown in FIG. 2 and FIG. 3, the first detection branch 10 includes a first impedance unit 11, a second impedance unit 12, and a first voltage collection unit 13. The first impedance unit 11 is separately connected to the first node P1 and the second node P2, and the second impedance unit 12 is separately connected to the second node P2 and the third node P3.

When the first detection branch 10 is configured to detect the voltage between the first node P1 and the second node P2, and does not need to detect the voltage between the second node P2 and the third node P3, one first voltage collection unit 13 may be disposed, and the first voltage collection unit 13 is connected to the first impedance unit 11, as shown in FIG. 2. Alternatively, when the first detection branch 10 is configured to detect the voltage between the second node P2 and the third node P3, and does not need to detect the voltage between the first node P1 and the second node P2, one first voltage collection unit 13 may also be disposed, and the first voltage collection unit 13 is connected to the second impedance unit 12, as shown in FIG. 3. Alternatively, when the first detection branch 10 is configured to detect both the voltage between the first node P1 and the second node P2 and the voltage between the second node P2 and the third node P3, two first voltage collection units 13 may be disposed, one of the first voltage collection units 13 is connected to the first impedance unit 11, and the other first voltage collection unit 13 is connected to the second impedance unit 12. This is not shown in a figure.

In this way, when the first relay k1 is adhered, the first node P1 and the second node P2 are short-circuited, so that potentials of the first node P1 and the second node P2 are the same or approximately the same. Therefore, a current does not pass through the first impedance unit 11, but directly flows from the first node P1 to the second node P2. If the first voltage collection unit 13 is connected to the first impedance unit 11, as shown in FIG. 2, a voltage collected in this case is zero, or is close to zero, or is a value that is very small compared with the output voltage. In this case, it may be determined that the first relay k1 is adhered. If the first voltage collection unit 13 is connected to the second impedance unit 12, as shown in FIG. 3, because the second impedance unit 12 is separately connected to the second node P2 and the third node P3, and the potentials of the second node P2 and the first node P1 are almost the same, a voltage collected by the first voltage collection unit 13 is close to the output voltage of the power supply m1. In this case, the voltage collected by the first voltage collection unit 13 is compared with the output voltage. If the collected voltage is close to the output voltage, it may be determined that the first relay k1 is adhered.

When the first relay k1 is normally disconnected, the first node P1 and the second node P2 are completely disconnected. Therefore, impedance between the first node P1 and the second node P2 is very large, and a current passes through the first impedance unit 11. If the first voltage collection unit 13 is connected to the first impedance unit 11, as shown in FIG. 2, a voltage collected in this case is a voltage drop generated by the first impedance unit 11. If the first voltage collection unit 13 is connected to the second impedance unit 12, as shown in FIG. 3, a voltage collected in this case is a voltage drop generated by the second impedance unit 12. In this case, it may be determined, by comparing the collected voltage with the output voltage, that the first relay k1 is normally disconnected.

In some embodiments, as shown in FIG. 2 and FIG. 3, the second detection branch 20 includes a third impedance unit 21, a fourth impedance unit 22, and a second voltage collection unit 23. The third impedance unit 21 is separately connected to the third node P3 and the fourth node P4, and the fourth impedance unit 22 is separately connected to the fourth node P4 and the first node P1.

When the second detection branch 20 is configured to detect the voltage between the third node P3 and the fourth node P4, and does not need to detect the voltage between the fourth node P4 and the first node P1, one second voltage collection unit 23 may be disposed, and the second voltage collection unit 23 is connected to the third impedance unit 21, as shown in FIG. 3. Alternatively, when the second detection branch 20 is configured to detect the voltage between the fourth node P4 and the first node P1, and does not need to detect the voltage between the third node P3 and the fourth node P4, one second voltage collection unit 23 may be disposed, and the second voltage collection unit 23 is connected to the fourth impedance unit 22, as shown in FIG. 2. Alternatively, when the second detection branch 20 is configured to detect both the voltage between the third node P3 and the fourth node P4 and the voltage between the fourth node P4 and the first node P1, two second voltage collection units 23 are disposed, one of the second voltage collection units 23 is connected to the third impedance unit 21, and the other second voltage collection unit 23 is connected to the fourth impedance unit 22. This is not shown in a figure.

In this way, when the second relay k2 is adhered, the third node P3 and the fourth node P4 are short-circuited, so that potentials of the third node P3 and the fourth node P4 are the same or approximately the same. Therefore, a current does not pass through the third impedance unit 21, but directly flows from the fourth node P4 to the third node P3. If the second voltage collection unit 23 is connected to the third impedance unit 21, as shown in FIG. 3, a voltage collected in this case is zero, or is close to zero, or is a value that is very small compared with the output voltage. In this case, it may be determined that the second relay k2 is adhered. If the second voltage collection unit 23 is connected to the fourth impedance unit 22, as shown in FIG. 2, because the fourth impedance unit 22 is separately connected to the first node P1 and the fourth node P4, and the potentials of the fourth node P4 and the third node P3 are almost the same, a voltage collected by the second voltage collection unit 23 is close to the output voltage of the power supply m1. In this case, the voltage collected by the second voltage collection unit 23 is compared with the output voltage. If the collected voltage is close to the output voltage, it may be determined that the second relay k2 is adhered.

When the second relay k2 is normally disconnected, the third node P3 and the fourth node P4 are completely disconnected. Therefore, impedance between the third node P3 and the fourth node P4 is very large, and a current passes through the third impedance unit 21. If the second voltage collection unit 23 is connected to the third impedance unit 21, as shown in FIG. 3, a voltage collected in this case is a voltage drop generated by the third impedance unit 21. If the second voltage collection unit 23 is connected to the fourth impedance unit 22, as shown in FIG. 2, a voltage collected in this case is a voltage drop generated by the fourth impedance unit 22. In this case, it may be determined that the second relay k2 is normally disconnected.

It should be understood that disposing of the second detection branch is not limited by a disposing manner of the first detection branch. Similarly, disposing of the first detection branch is not limited by a disposing manner of the second detection branch. The first detection branch and the second detection branch may both be independently disposed based on an actual requirement.

The structure shown in FIG. 3 is used as an example, and a filter capacitor C0 may be further disposed between the two lines. The filter capacitor C0 is disposed between the two lines, and the filter capacitor C0 has a characteristic of allowing an alternating current to pass through and blocking a direct current. Therefore, when the power supply m1 outputs an alternating current signal, the alternating current signal may pass through the filter capacitor C0, and an impedance value of the filter capacitor C0 is generally not large, or an impedance value of the filter capacitor C0 is generally much less than impedance values of the first impedance unit 11, the second impedance unit 12, the third impedance unit 21, and the fourth impedance unit 22. When the power supply m1 outputs a direct current signal, the filter capacitor C0 may be considered as very large impedance, and the direct current signal generally does not pass through the filter capacitor C0. Therefore, when a type of a signal output by the power supply m1 is different, there is a difference in performing adhesion determining based on voltages collected by the first voltage collection unit 13 and the second voltage collection unit 23. Details are as follows:

### 1. The power supply m1 outputs an alternating current signal.

If the first relay k1 is normally disconnected, and the second relay k2 is adhered, because the filter capacitor C0 and the second impedance unit 12 are disposed in parallel, and the impedance value of the filter capacitor C0 is much less than an impedance value of the second impedance unit 12, the alternating current signal returns to the power supply m1 through the filter capacitor C0 after passing through the first impedance unit 11, and few alternating current signals flow through the second impedance unit 12, so that a current flowing through the second impedance unit 12 is relatively small and is close to zero. Therefore, when the first voltage collection unit 13 is connected to the second impedance unit 12, a divided voltage that is of the second impedance unit 12 and that is collected by the first voltage collection unit 13 is very small compared with the output voltage or is close to zero. When the second voltage collection unit 23 is connected to the third impedance unit 21, because the second relay k2 is adhered, a collected voltage is also very small compared with the output voltage or is close to zero.

If the first relay k1 is adhered, and the second relay k2 is normally disconnected, because the second impedance unit 12 is separately connected to the second node P2 and the third node P3, when the potentials of the first node P1 and the second node P2 are the same, a divided voltage of the second impedance unit 12 is a voltage between the first node P1 and the third node P3. In addition, because the voltage between the first node P1 and the third node P3 is the output voltage, the divided voltage of the second impedance unit 12 is the output voltage. When the first voltage collection unit 13 is connected to the second impedance unit 12, a collected voltage is close to the output voltage. Because the first relay k1 is adhered, the fourth impedance unit 22 and the filter capacitor C0 are in a parallel connection relationship. When the impedance value of the filter capacitor C0 is much less than an impedance value of the fourth impedance unit 22, a current flowing through the fourth impedance unit 22 is very small. In this case, it is temporarily considered that the current flowing through the fourth impedance unit 22 is zero, and therefore, it is temporarily considered that a divided voltage of the fourth impedance unit 22 is zero. When the second relay k2 is normally disconnected, the power supply, the filter capacitor C0, and the third impedance unit 21 may form a current loop. When the impedance value of the filter capacitor C0 is much less than the impedance value of the fourth impedance unit 22, a divided voltage of the third impedance unit 21 is close to the output voltage. Therefore, when the second voltage collection unit 23 is connected to the third impedance unit 21, a collected voltage is close to the output voltage. If the first relay k1 is adhered, and the second relay k2 is adhered, similarly, if the voltage collected by the first voltage collection unit 13 is close to the output voltage, and the voltage collected by the second voltage collection unit 23 is very small compared with the output voltage or is close to zero, it may be determined that the first relay k1 is adhered, and the second relay k2 is adhered.

If the first relay k1 is normally disconnected, and the second relay k2 is normally disconnected, the alternating current signal separately passes through the first detection branch 10 and the second detection branch 20. Therefore, when the first voltage collection unit 13 is connected to the second impedance unit 12, a collected voltage is a divided voltage that is of the second impedance unit 12 and that is obtained through voltage division between the first impedance unit 11 and the second impedance unit 12. When impedance of the first impedance unit 11 is represented by R1, impedance of the second impedance unit 12 is represented by R2, and the output voltage is represented by Vs, the collected voltage is close to R2*Vs/(R1+R2). When the second voltage collection unit 23 is connected to the third impedance unit 21, a collected voltage is a divided voltage that is of the third impedance unit 21 and that is obtained through voltage division between the third impedance unit 21 and the fourth impedance unit 22. When impedance of the third impedance unit 21 is represented by R3, and impedance of the fourth impedance unit 22 is represented by R4, the collected voltage is close to R3*Vs/(R3+R4).

Based on this, when the power supply m1 outputs an alternating current signal, and the first relay k1 and the second relay k2 are in different statuses, the voltages collected by the first voltage collection unit 13 and the second voltage collection unit 23 are shown in Table 1 below. In Table 1, V1 represents a voltage collected when the first voltage collection unit 13 is connected to the second impedance unit 12, V2 represents a voltage collected when the second voltage collection unit 23 is connected to the third impedance unit 21, and Vs represents the output voltage of the power supply m1.

**Table 1**

| First relay k1 | Second relay k2 | V1 | V2 | V1-V2 |
|---|---|---|---|---|
| Normally disconnected | Normally disconnected | ≈R2*Vs/(R1+R2) | ≈R3*Vs/(R3+R4) | ≈R2*Vs/(R1+R2)-R3*Vs/(R3+R4) |
| Normally disconnected | Adhered | ≈0 | ≈0 | ≈0 |
| Adhered | Normally disconnected | ≈Vs | ≈Vs | ≈0 |
| Adhered | Adhered | ≈Vs | ≈0 | ≈Vs |

Based on a result provided in Table 1, when the power supply m1 outputs an alternating current signal, whether the first relay k1 and the second relay k2 are adhered may be determined by using the voltages collected by the first voltage collection unit 13 and the second voltage collection unit 23. In addition, if the determining is referred to as initial determining, a difference (that is, V1-V2 in Table 1) between the voltages collected by the first voltage collection unit 13 and the second voltage collection unit 23 may be further calculated, and whether the first relay k1 and the second relay k2 are adhered may be redetermined based on the difference, or whether a result of the initial determining is accurate may be verified based on a determining result that is based on the difference, thereby further improving determining accuracy and reducing erroneous determining.

### 2. The power supply m1 outputs a direct current signal.

If the first relay k1 is normally disconnected, and the second relay k2 is adhered, although the filter capacitor C0 and the second impedance unit 12 are disposed in parallel, because the impedance value of the filter capacitor C0 is much greater than an impedance value of the second impedance unit 12, the direct current signal returns to the power supply m1 through the second impedance unit 12 after passing through the first impedance unit 11. Therefore, the voltage collected by the first voltage collection unit 13 is a divided voltage that is of the second impedance unit 12 and that is obtained through voltage division between the first impedance unit 11 and the second impedance unit 12. When impedance of the first impedance unit 11 is represented by R1, impedance of the second impedance unit 12 is represented by R2, and the output voltage is represented by Vs, the collected voltage is close to R2*Vs/(R1+R2). When the second voltage collection unit 23 is connected to the third impedance unit 21, because the second relay k2 is adhered, a collected voltage is very small compared with the output voltage or is close to zero.

If the first relay k1 is adhered, and the second relay k2 is normally disconnected, because the second impedance unit 12 is separately connected to the second node P2 and the third node P3, when the potentials of the first node P1 and the second node P2 are the same, a divided voltage of the second impedance unit 12 is a voltage between the first node P1 and the third node P3. In addition, because the voltage between the first node P1 and the third node P3 is the output voltage, the divided voltage of the second impedance unit 12 is the output voltage. When the first voltage collection unit 13 is connected to the second impedance unit 12, a collected voltage is close to the output voltage. Because the first relay k1 is adhered, the fourth impedance unit 22 and the filter capacitor C0 are in a parallel connection relationship. When the impedance value of the filter capacitor C0 is much greater than an impedance value of the fourth impedance unit 22, a current flowing through the filter capacitor C0 is very small and close to zero. Therefore, the fourth impedance unit 22, the third impedance unit 21, and the power supply m1 may form a current loop. When the second voltage collection unit 23 is connected to the third impedance unit 21, a collected voltage is close to a divided voltage that is of the third impedance unit 21 and that is obtained through voltage division between the third impedance unit 21 and the fourth impedance unit 22. When impedance of the third impedance unit 21 is represented by R3, and impedance of the fourth impedance unit 22 is represented by R4, the collected voltage is close to R3*Vs/(R3+R4).

If the first relay k1 is adhered, and the second relay k2 is adhered, similarly, if the voltage collected by the first voltage collection unit 13 is close to the output voltage, and the voltage collected by the second voltage collection unit 23 is very small compared with the output voltage or is close to zero, it may be determined that the first relay k1 is adhered, and the second relay k2 is adhered.

If the first relay k1 is normally disconnected, and the second relay k2 is normally disconnected, similarly, when the first voltage collection unit 13 is connected to the second impedance unit 12, a collected voltage is close to a divided voltage that is of the second impedance unit 12 and that is obtained through voltage division between the first impedance unit 11 and the second impedance unit 12, that is, R2*Vs/(R1+R2). When the second voltage collection unit 23 is connected to the third impedance unit 21, a collected voltage is close to a divided voltage that is of the third impedance unit 21 and that is obtained through voltage division between the third impedance unit 21 and the fourth impedance unit 22, that is, R3*Vs/(R3+R4).

Based on this, when the power supply m1 outputs a direct current signal, and the first relay k1 and the second relay k2 are in different statuses, the voltages collected by the first voltage collection unit 13 and the second voltage collection unit 23 are shown in Table 2 below. In Table 2, V1 represents a voltage collected when the first voltage collection unit 13 is connected to the second impedance unit 12, V2 represents a voltage collected when the second voltage collection unit 23 is connected to the third impedance unit 21, and Vs represents the output voltage of the power supply m1.

**Table 2**

| First relay k1 | Second relay k2 | V1 | V2 | V1-V2 |
|---|---|---|---|---|
| Normally disconnected | Normally disconnected | ≈R2*Vs/(R1+R2) | ≈R3*Vs/(R3+R4) | ≈R2*Vs/(R1+R2)-R3*Vs/(R3+R4) |
| Normally disconnected | Adhered | ≈R2*Vs/(R1+R2) | ≈0 | ≈R2*Vs/(R1+R2) |
| Adhered | Normally disconnected | ≈Vs | ≈R3*Vs/(R3+R4) | R3*Vs/(R3+R4) |
| Adhered | Adhered | ≈Vs | ≈0 | ≈Vs |

Based on a result provided in Table 2, when the power supply m1 outputs a direct current signal, whether the first relay k1 and the second relay k2 are adhered may be determined by using the voltages collected by the first voltage collection unit 13 and the second voltage collection unit 23. In addition, if the determining is referred to as initial determining, a difference (that is, V1-V2 in Table 2) between the voltages collected by the first voltage collection unit 13 and the second voltage collection unit 23 may be further calculated, and whether the first relay k1 and the second relay k2 are adhered may be redetermined based on the difference, or whether a result of the initial determining is accurate may be verified based on a determining result that is based on the difference, thereby further improving determining accuracy and reducing erroneous determining.

Therefore, the detection circuit provided in this embodiment of this application may be applied not only to an alternating current scenario, but also to a direct current scenario. In addition, especially in a scenario in which input frequently fluctuates, the detection circuit may adjust potentials of contacts of the two relays to ground, so that the two relays are not affected by a Y capacitor, thereby ensuring normal working of the two relays.

In some embodiments, the impedance values of the first impedance unit, the second impedance unit, the third impedance unit, and the fourth impedance unit may all be set to be the same. In this case, it may be directly determined whether the voltages collected by the first voltage collection unit and the second voltage collection unit are close to zero, the output voltage, or half of the output voltage. In this way, a calculation amount and an arithmetic operation amount may be reduced, and determining efficiency may be improved. Certainly, the impedance values of the first impedance unit, the second impedance unit, the third impedance unit, and the fourth impedance unit may alternatively be set to be at least partially different. In this case, the impedance values of the impedance units may be adjusted based on actual requirements to meet requirements of different application scenarios, thereby improving design flexibility. In some embodiments, when the power supply is configured to output an alternating current signal, at least one of the first impedance unit, the second impedance unit, the third impedance unit, and the fourth impedance unit may include at least one of an inductor, a resistor, and a capacitor. When the power supply is configured to output a direct current signal, at least one of the first impedance unit, the second impedance unit, the third impedance unit, and the fourth impedance unit may include at least one of a resistor and a capacitor. In this way, structures of the impedance units may be set for different application scenarios, so that design flexibility may be improved.

In addition, the structures of the first impedance unit, the second impedance unit, the third impedance unit, and the fourth impedance unit may all be set to be the same, to simplify a structure of the detection circuit, and reduce manufacturing difficulty and a manufacturing cost that are of the detection circuit. Certainly, the structures of the first impedance unit, the second impedance unit, the third impedance unit, and the fourth impedance unit may alternatively be set to be at least partially different, so that requirements of different application scenarios may be met, and design flexibility may be improved.

In some embodiments, the output voltage of the power supply m1 may be obtained from a supplier of the power supply; or a third voltage collection unit 30 connected between the two lines may be disposed, and the output voltage is collected by using the third voltage collection unit 30, as shown in FIG. 2. In addition, structures of the first voltage collection unit 13, the second voltage collection unit 23, and the third voltage collection unit 30 may all be set to be the same, to simplify the structure of the detection circuit, and reduce the manufacturing difficulty and the manufacturing cost that are of the detection circuit. Certainly, the structures of the first voltage collection unit 13, the second voltage collection unit 23, and the third voltage collection unit 30 may alternatively be set to be at least partially different, so that requirements of different application scenarios may be met, and design flexibility may be improved. It should be understood that, when the third voltage collection unit 30 is not disposed, structures of the first voltage collection unit 13 and the second voltage collection unit 23 may be set to be the same or different.

In some embodiments, when the first voltage collection unit is connected to the first impedance unit, the first impedance unit may be a part of the first voltage collection unit, that is, the first impedance unit and the first voltage collection unit belong to a same independent component; or when the first voltage collection unit is connected to the second impedance unit, the second impedance unit may be a part of the first voltage collection unit, that is, the second impedance unit and the first voltage collection unit belong to a same independent component. Similarly, when the second voltage collection unit is connected to the third impedance unit, the third impedance unit may be a part of the second voltage collection unit, that is, the third impedance unit and the second voltage collection unit belong to a same independent component; or when the second voltage collection unit is connected to the fourth impedance unit, the fourth impedance unit may be a part of the second voltage collection unit, that is, the fourth impedance unit and the second voltage collection unit belong to a same independent component.

In some embodiments, specific structures of the first voltage collection unit, the second voltage collection unit, and the third voltage collection unit are not limited herein. Any structure that can implement voltage collection falls within the protection scope of this embodiment of this application.

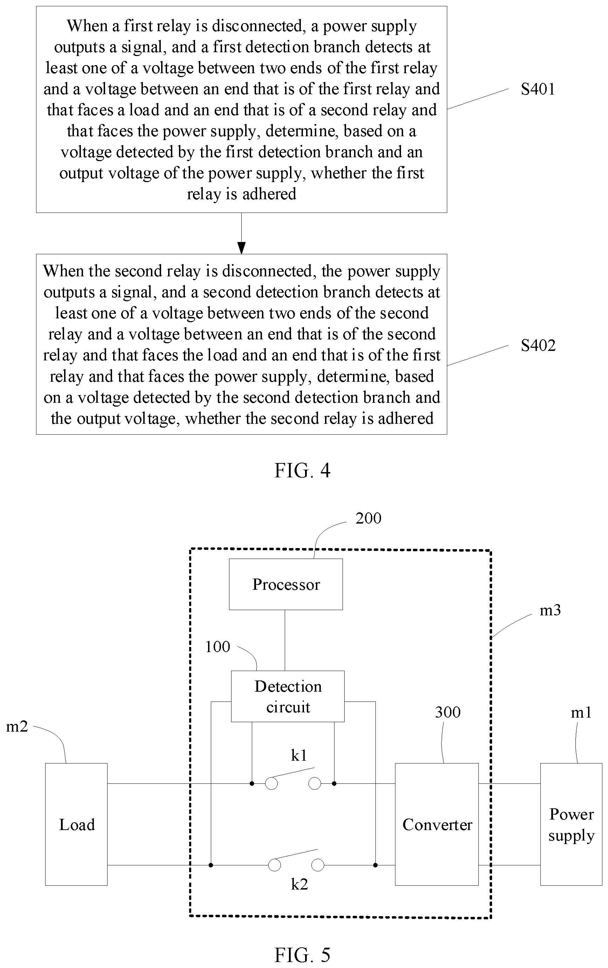

Based on this, when the foregoing detection circuit is used to detect adhesion statuses of the relays, as shown in FIG. 4, the following process may be included:
S401: When the first relay is disconnected, the power supply outputs a signal, and the first detection branch detects at least one of the voltage between the two connection ends of the first relay and the voltage between the connection end that is of the first relay and that is directly connected to the load and the connection end that is of the second relay and that is directly connected to the power supply, determine, based on the voltage detected by the first detection branch and the output voltage of the power supply, whether the first relay is adhered.
S402: When the second relay is disconnected, the power supply outputs a signal, and the second detection branch detects at least one of the voltage between the two connection ends of the second relay and the voltage between the connection end that is of the second relay and that is directly connected to the load and the connection end that is of the first relay and that is directly connected to the power supply, determine, based on the voltage detected by the second detection branch and the output voltage, whether the second relay is adhered.

In this way, whether the first relay is adhered may be determined by comparing the voltage detected by the first detection branch with the output voltage, and whether the second relay is adhered may be determined by comparing the voltage detected by the second detection branch with the output voltage, thereby detecting the adhesion status of each relay. In addition, during voltage detection, detection may be performed based on a specified collection cycle, or detection may be triggered at any time based on a requirement. Because voltage detection is not limited by a power-off sequence and a power-off interval of the two relays, detection efficiency may be improved, thereby improving relay determining efficiency.

In some embodiments, when S401 is performed, the following may be specifically included:
When the first relay is disconnected:
If a first voltage between the two connection ends of the first relay (that is, the voltage between the first node P1 and the second node P2) is detected, as shown in FIG. 2, if the first voltage is not greater than a first preset value, it may be determined that the first relay is adhered. If the first voltage meets a first condition, and the first condition includes that when the power supply is configured to output an alternating current signal, the first voltage is within the output voltage ± the first preset value, or when the power supply is configured to output a direct current signal, the first voltage is within a divided voltage that is of the first impedance unit and that is obtained through voltage division between the first impedance unit and the second impedance unit ± the first preset value, it may be determined that the first relay is normally disconnected and is not adhered.

If a first voltage between the connection end (that is, the second node P2) that is of the first relay and that is directly connected to the load and the connection end (that is, the third node P3) that is of the second relay and that is directly connected to the power supply is detected, as shown in FIG. 3, if the first voltage is within the output voltage ± the first preset value, it may be determined that the first relay is adhered. If the first voltage meets a second condition, and the second condition includes that when the power supply is configured to output an alternating current signal, the first voltage is not less than the first preset value, or when the power supply is configured to output a direct current signal, the first voltage is within the divided voltage that is of the second impedance unit and that is obtained through voltage division between the first impedance unit and the second impedance unit ± the first preset value, it may be determined that the first relay is normally disconnected and is not adhered.

The first preset value is not less than 0 and is not greater than 15% of the output voltage. For example, the first preset value is but not limited to 0, 5% of the output voltage, 8% of the output voltage, 10% of the output voltage, or another value. This is not limited herein.

In this way, based on the foregoing process, it may be determined whether the first relay is adhered.

In some embodiments, when S402 is performed, the following may be specifically included:
When the second relay is disconnected:
If a second voltage between the two connection ends of the second relay (that is, the voltage between the third node P3 and the fourth node P4) is detected, as shown in FIG. 3, if the second voltage is not less than a second preset value, it may be determined that the second relay is adhered. If the second voltage meets a third condition, and the third condition includes that when the power supply is configured to output an alternating current signal, the second voltage is within the output voltage ± the second preset value, or when the power supply is configured to output a direct current signal, the second voltage is within the divided voltage that is of the third impedance unit and that is obtained through voltage division between the third impedance unit and the fourth impedance unit ± the second preset value, it may be determined that the second relay is normally disconnected and is not adhered.

If a second voltage between the connection end (that is, the fourth node P4) that is of the second relay and that is directly connected to the load and the connection end (that is, the first node P1) that is of the first relay and that is directly connected to the power supply is detected, as shown in FIG. 2, if the second voltage is within the output voltage ± the second preset value, it may be determined that the second relay is adhered. If the second voltage meets a fourth condition, and the fourth condition includes that when the power supply is configured to output an alternating current signal, the second voltage is not less than the second preset value, or when the power supply is configured to output a direct current signal, the second voltage is within the divided voltage that is of the fourth impedance unit and that is obtained through voltage division between the third impedance unit and the fourth impedance unit ± the second preset value, it may be determined that the second relay is normally disconnected and is not adhered.

The second preset value is not less than 0 and is not greater than 15% of the output voltage. For example, the second preset value is but not limited to 0, 5% of the output voltage, 8% of the output voltage, 10% of the output voltage, or another value. This is not limited herein. In addition, the first preset value and the second preset value may be set to be the same or different. This may be specifically determined based on an actual situation.

In this way, based on the foregoing process, it may be determined whether the second relay is adhered.

In some embodiments, in addition to directly determining, based on the first voltage detected by the first detection branch and the second voltage detected by the second detection branch, whether the relays are adhered, a difference between the first voltage and the second voltage may be further calculated, and whether the relays are adhered may be redetermined based on the difference and the output voltage, to further verify a determining result, thereby improving accuracy of the determining result.

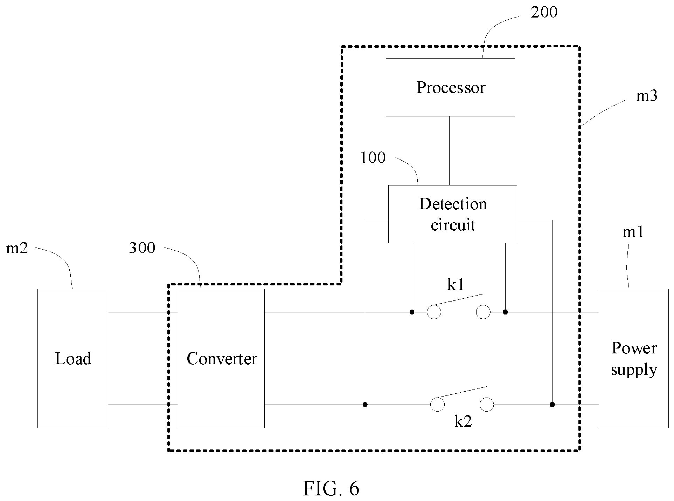

Based on the foregoing solution, an example useful for understanding the invention further provides a power adapter. As shown in FIG. 5 and FIG. 6, the power adapter m3 may include a first relay k1, a second relay k2, a detection circuit 100, a converter 300, and a processor 200. In two lines connected to the converter 300, the first relay k1 is disposed in one of the lines, and the second relay k2 is disposed in the other line. In addition, the two lines connected to the converter 300 may be two lines that connect the converter 300 and a power supply m1, as shown in FIG. 6. When the first relay k1 and the second relay k2 are respectively disposed in the two lines, the detection circuit 100 needs to be disposed to connect to the two lines. Certainly, the two lines connected to the converter 300 may alternatively be two lines that connect the converter 300 and a load m2, as shown in FIG. 5. When the first relay k1 and the second relay k2 are respectively disposed in the two lines, the detection circuit 100 needs to be disposed to connect to the two lines. Therefore, the detection circuit 100 may be disposed in the two lines between the converter 300 and the load m2, and may alternatively be disposed in the two lines between the converter 300 and the power supply m1.

The detection circuit 100 is separately connected to two connection ends of the first relay k1, two connection ends of the second relay k2, and the processor 200. As shown in FIG. 5, when the detection circuit 100 is connected to the two lines between the converter 300 and the load m2, because the converter 300 provides electric energy for the load m2, the converter 300 may be considered as the power supply in FIG. 2 and FIG. 3. In this case, the detection circuit 100 may be configured to: when the first relay k1 and the second relay k2 are both disconnected, and a current passes through the two lines and the detection circuit 100, detect at least one of a voltage between the two connection ends of the first relay k1 and a voltage between a connection end that is of the first relay k1 and that is away from the converter 300 and a connection end that is of the second relay k2 and that faces the converter 300, and detect at least one of a voltage between the two connection ends of the second relay k2 and a voltage between an end that is of the second relay k2 and that is away from the converter 300 and a connection end that is of the first relay k1 and that faces the converter 300.

As shown in FIG. 6, when the detection circuit 100 is connected to the two lines between the power supply m1 and the converter 300, because the power supply m1 provides electric energy for the converter 300, the converter 300 may be considered as the load in FIG. 2 and FIG. 3. In this case, the detection circuit 100 may be configured to: when the first relay k1 and the second relay k2 are both disconnected, and a current passes through the two lines and the detection circuit 100, detect at least one of a voltage between the two connection ends of the first relay k1 and a voltage between a connection end that is of the first relay k1 and that faces the converter 300 and a connection end that is of the second relay k2 and that is away from the converter 300, and detect at least one of a voltage between the two connection ends of the second relay k2 and a voltage between a connection end that is of the second relay k2 and that faces the converter 300 and a connection end that is of the first relay k1 and that is away from the converter 300.

In addition, the detection circuit 100 transmits a detected voltage to the processor 200, and the processor 200 may determine, based on the voltage detected by the detection circuit 100 and a voltage between the two lines, whether the first relay k1 and the second relay k2 are adhered.

In this way, whether each relay is adhered may be determined by comparing the voltage detected by the detection circuit with an output voltage between the two lines. In this adhesion detection manner, a structure of a relay does not need to be changed, so that increases in a manufacturing cost and a volume that are of the relay may be avoided, thereby implementing adhesion detection on a basis of keeping an original structure unchanged. In addition, during voltage detection, detection may be performed based on a specified collection cycle, or detection may be triggered at any time based on a requirement. Because voltage detection is not limited by a power-off sequence and a power-off interval of the two relays, detection efficiency may be improved, thereby improving relay determining efficiency.

In some examples, the voltage between the two lines may be transmitted to the processor or pre-built in the processor, and the processor may compare the detected voltage with the voltage between the two lines, to determine whether each relay is adhered, and then output a determining result. When the processor outputs the determining result, if the processor is connected to a display, the determining result may be displayed by using the display, and if the processor is connected to an alarm, the determining result may be reflected by using different alarm sounds emitted by the alarm or alarm indicators of different colors. Certainly, another manner that can reflect the determining result and that is well known by a person skilled in the art may also be used. This is not limited herein.

A specific implementation principle of the detection circuit in the power adapter is similar to an implementation principle of the foregoing detection circuit. For a specific implementation of the detection circuit in the power adapter, refer to the specific embodiment of the foregoing detection circuit. No repeated description is provided.

In some examples, as shown in FIG. 5 and FIG. 6, when the power adapter m3 is disposed between the power supply m1 and the load m2, the converter 300 is separately connected to the power supply m1 and the load m2. In this case, the converter 300 may perform voltage conversion processing and power conversion processing on a signal output by the power supply m1, and then transmit the signal to the load m2, so that the load m2 uses the signal and is driven to work. The power supply m1 may be an alternating current source configured to provide an alternating current signal, or a direct current source configured to provide a direct current signal. The alternating current source may be but is not limited to an alternating current power grid, an alternating current charging pile, or the like. The direct current source may be but is not limited to a photovoltaic power supply, a direct current charging pile, or the like. In addition, if the first relay k1 and the second relay k2 are respectively disposed in the two lines between the converter 300 and the power supply m1, as shown in FIG. 6, the detection circuit 100 may be separately connected to the two lines between the converter 300 and the power supply m1. In this case, the voltage between the two lines may be considered as an output voltage of the power supply m1. If the first relay k1 and the second relay k2 are respectively disposed in the two lines between the converter 300 and the load m2, as shown in FIG. 5, the detection circuit 100 may be separately connected to the two lines between the converter 300 and the load m2. In this case, the voltage between the two lines may be considered as an output voltage of the converter 300.

In some examples, when the detection circuit 100 includes two detection branches, each detection branch can detect a voltage. One of the detection branches is configured to detect at least one of a voltage between a first connection end of the first relay k1 and a second connection end of the first relay k1 and a voltage between the first connection end of the first relay k1 and a second connection end of the second relay k2, and the other detection branch is configured to detect at least one of a voltage between a first connection end of the second relay k2 and the second connection end of the second relay k2 and a voltage between the first connection end of the second relay k2 and the second connection end of the first relay k1. In this case, the processor 200 may further calculate a difference between voltages respectively detected by the two detection branches, and redetermine, based on the difference and the voltage between the two lines, whether the first relay k1 and the second relay k2 are adhered. In this way, further determining may be performed on whether there is adhesion, thereby improving accuracy of a determining result.

In some examples, in addition to the foregoing structure, the power adapter may include another structure configured to implement a function of the power adapter, for example, but not limited to, an output interface or a rectifier module. This is not limited herein.

Although some preferred embodiments of this application have been described, a person skilled in the art can make changes and modifications to these embodiments once they learn the basic inventive concept. Therefore, the following claims are intended to define the scope of the present invention.

## Claims

1. A relay adhesion detection circuit (100), wherein in two lines between a power supply (m1) and a load (m2), a first relay (k1) is disposed in one of the lines, and a second relay (k2) is disposed in the other line;
the detection circuit (100) comprises two detection branches (10, 20);
one (10) of the detection branches is separately electrically connected to two connection ends (P1; P2) of the first relay (k1) and a connection end (P3)
that is of the second relay (k2) and that is directly connected to the power supply (m1), and the other detection branch (20)
is separately electrically connected to two connection ends of the second relay (k2) and a connection end that is of the first relay (k1) and that is directly connected to the power supply (m1); and
each detection branch is configured:
when the first relay (k1) and the second relay (k2) are both disconnected, and the power supply (m1) outputs a signal, to detect at least one of a voltage between two connection ends of a corresponding relay and a voltage between one connection end of the first relay (k1) and the other connection end of the second relay (k2),
to determine, based on the detected voltage or voltages and an output voltage of the power supply (m1), whether the corresponding relay is adhered,
wherein in the one connection end of the first relay (k1) and the other connection end of the second relay (k2), one is directly connected to the power supply (m1), and the other is directly connected to the load (m2).

2. The detection circuit (100) according to claim 1, wherein the detection branch connected to the two connection ends of the first relay (k1) is specifically configured to:
detect at least one of a voltage between the two connection ends of the first relay (k1) and a voltage between a connection end that is of the first relay (k1) and that is directly connected to the load (m2) and a connection end that is of the second relay (k2) and that is directly connected to the power supply (m1), to determine, based on a detected voltage and the output voltage, whether the first relay (k1) is adhered.

3. The detection circuit (100) according to claim 1 or 2, wherein the detection branch connected to the two connection ends of the first relay (k1) comprises a first impedance unit (11), a second impedance unit (12), and a first voltage collection unit (13);
the first impedance unit (11) is separately electrically connected to the two connection ends of the first relay (k1), and the second impedance unit (12) is separately electrically connected to the connection end that is of the first relay (k1) and that is directly connected to the load (m2) and the connection end that is of the second relay (k2) and that is directly connected to the power supply (m1); and
at least one of the first impedance unit (11) and the second impedance unit (12) is electrically connected to the first voltage collection unit (13), and the first voltage collection unit (13) is configured to collect the at least one of the voltage between the two connection ends of the first relay (k1) and the voltage between the connection end that is of the first relay (k1) and that is directly connected to the load (m2) and the connection end that is of the second relay (k2) and that is directly connected to the power supply (m1).

4. The detection circuit (100) according to claim 1, wherein the detection branch connected to the two connection ends of the second relay (k2) is specifically configured to:
detect at least one of a voltage between the two connection ends of the second relay (k2) and a voltage between a connection end that is of the second relay (k2) and that is directly connected to the load (m2) and a connection end that is of the first relay (k1) and that is directly connected to the power supply (m1), to determine, based on the detected voltage or voltages and the output voltage, whether the second relay (k2) is adhered.

5. The detection circuit (100) according to any one of claims 1 to 4, wherein the detection branch connected to the two connection ends of the second relay (k2) comprises a third impedance unit (21), a fourth impedance unit (22), and a second voltage collection unit (23);
the third impedance unit (21) is separately electrically connected to the two connection ends of the second relay (k2), and the fourth impedance unit (22) is separately electrically connected to the connection end that is of the first relay (k1) and that is directly connected to the power supply (m1) and the connection end that is of the second relay (k2) and that is directly connected to the load (m2); and
at least one of the third impedance unit (21) and the fourth impedance unit (22) is electrically connected to the second voltage collection unit (23), and the second voltage collection unit (23) is configured to collect the at least one of the voltage between the two connection ends of the second relay (k2) and the voltage between the connection end that is of the second relay (k2) and that is directly connected to the load (m2) and the connection end that is of the first relay (k1) and that is directly connected to the power supply (m1).

6. The detection circuit (100) according to claim 5, wherein the power supply (m1) is configured to output an alternating current signal, and at least one of the first impedance unit (11), the second impedance unit (12), the third impedance unit (21), and the fourth impedance unit (22) comprises at least one of an inductor, a resistor, and a capacitor.

7. The detection circuit (100) according to claim 5, wherein the power supply (m1) is configured to output a direct current signal, and at least one of the first impedance unit (11), the second impedance unit (12), the third impedance unit (21), and the fourth impedance unit (22) comprises at least one of a resistor and a capacitor.

## Patentansprüche

1. Relaishaftungsdetektionsschaltung (100), wobei in zwei Leitungen zwischen einer Stromversorgung (m1) und einem Verbraucher (m2) ein erstes Relais (k1) in einer der Leitungen angeordnet ist und ein zweites Relais (k2) in der anderen Leitung angeordnet ist;
die Detektionsschaltung (100) zwei Detektionszweige (10, 20) umfasst;
einer (10) der Detektionszweige separat elektrisch mit zwei Verbindungsenden (P1; P2) des ersten Relais (k1) und einem Verbindungsende (P3) des zweiten Relais (k2), das direkt mit der Stromversorgung (m1) verbunden ist, verbunden ist und der andere Detektionszweig (20) separat elektrisch mit zwei Verbindungsenden des zweiten Relais (k2) und einem Verbindungsende des ersten Relais (k1), das direkt mit der Stromversorgung (m1) verbunden ist, verbunden ist; und
jeder Detektionszweig zu Folgendem konfiguriert ist:
wenn das erste Relais (k1) und das zweite Relais (k2) beide getrennt sind und die Stromversorgung (m1) ein Signal ausgibt, Detektieren mindestens einer von einer Spannung zwischen zwei Verbindungsenden eines entsprechenden Relais und einer Spannung zwischen einem Verbindungsende des ersten Relais (k1) und dem anderen Verbindungsende des zweiten Relais (k2) und Bestimmen, basierend auf der detektierten Spannung oder den detektierten Spannungen und einer Ausgangsspannung der Stromversorgung (m1), ob das entsprechende Relais haftet,
wobei von dem einen Verbindungsende des ersten Relais (k1) und dem anderen Verbindungsende des zweiten Relais (k2) eines direkt mit der Stromversorgung (m1) verbunden ist und das andere direkt mit dem Verbraucher (m2) verbunden ist.

2. Detektionsschaltung (100) nach Anspruch 1, wobei der Detektionszweig, der mit den zwei Verbindungsenden des ersten Relais (k1) verbunden ist, insbesondere zu Folgendem konfiguriert ist:
Detektieren mindestens einer von einer Spannung zwischen den zwei Verbindungsenden des ersten Relais (k1) und einer Spannung zwischen einem Verbindungsende des ersten Relais (k1), das direkt mit dem Verbraucher (m2) verbunden ist, und einem Verbindungsende des zweiten Relais (k2), das direkt mit der Stromversorgung (m1) verbunden ist, und Bestimmen, basierend auf einer detektierten Spannung und der Ausgangsspannung, ob das erste Relais (k1) haftet.

3. Detektionsschaltung (100) nach Anspruch 1 oder 2, wobei der Detektionszweig, der mit den zwei Verbindungsenden des ersten Relais (k1) verbunden ist, eine erste Impedanzeinheit (11), eine zweite Impedanzeinheit (12) und eine erste Spannungserfassungseinheit (13) umfasst;
die erste Impedanzeinheit (11) separat elektrisch mit den zwei Verbindungsenden des ersten Relais (k1) verbunden ist und die zweite Impedanzeinheit (12) separat elektrisch mit dem Verbindungsende des ersten Relais (k1), das direkt mit dem Verbraucher (m2) verbunden ist, und dem Verbindungsende des zweiten Relais (k2), das direkt mit der Stromversorgung (m1) verbunden ist, verbunden ist; und
mindestens eine von der ersten Impedanzeinheit (11) und der zweiten Impedanzeinheit (12) elektrisch mit der ersten Spannungserfassungseinheit (13) verbunden ist und die erste Spannungserfassungseinheit (13) dazu konfiguriert ist, die mindestens eine von der Spannung zwischen den zwei Verbindungsenden des ersten Relais (k1) und der Spannung zwischen dem Verbindungsende des ersten Relais (k1), das direkt mit dem Verbraucher (m2) verbunden ist, und dem Verbindungsende des zweiten Relais (k2), das direkt mit der Stromversorgung (m1) verbunden ist, zu erfassen.

4. Detektionsschaltung (100) nach Anspruch 1, wobei der Detektionszweig, der mit den zwei Verbindungsenden des zweiten Relais (k2) verbunden ist, insbesondere zu Folgendem konfiguriert ist:
Detektieren mindestens einer von einer Spannung zwischen den zwei Verbindungsenden des zweiten Relais (k2) und einer Spannung zwischen einem Verbindungsende des zweiten Relais (k2), das direkt mit dem Verbraucher (m2) verbunden ist, und einem Verbindungsende des ersten Relais (k1), das direkt mit der Stromversorgung (m1) verbunden ist, und Bestimmen, basierend auf der detektierten Spannung oder den detektierten Spannungen und der Ausgangsspannung, ob das zweite Relais (k2) haftet.

5. Detektionsschaltung (100) nach einem der Ansprüche 1 bis 4, wobei der Detektionszweig, der mit den zwei Verbindungsenden des zweiten Relais (k2) verbunden ist, eine dritte Impedanzeinheit (21), eine vierte Impedanzeinheit (22) und eine zweite Spannungserfassungseinheit (23) umfasst;
die dritte Impedanzeinheit (21) separat elektrisch mit den zwei Verbindungsenden des zweiten Relais (k2) verbunden ist und die vierte Impedanzeinheit (22) separat elektrisch mit dem Verbindungsende des ersten Relais (k1), das direkt mit der Stromversorgung (m1) verbunden ist, und dem Verbindungsende des zweiten Relais (k2), das direkt mit dem Verbraucher (m2) verbunden ist, verbunden ist; und
mindestens eine von der dritten Impedanzeinheit (21) und der vierten Impedanzeinheit (22) elektrisch mit der zweiten Spannungserfassungseinheit (23) verbunden ist und die zweite Spannungserfassungseinheit (23) dazu konfiguriert ist, die mindestens eine von der Spannung zwischen den zwei Verbindungsenden des zweiten Relais (k2) und der Spannung zwischen dem Verbindungsende des zweiten Relais (k2), das direkt mit dem Verbraucher (m2) verbunden ist, und dem Verbindungsende des ersten Relais (k1), das direkt mit der Stromversorgung (m1) verbunden ist, zu erfassen.

6. Detektionsschaltung (100) nach Anspruch 5, wobei die Stromversorgung (m1) dazu konfiguriert ist, ein Wechselstromsignal auszugeben, und wobei mindestens eine von der ersten Impedanzeinheit (11), der zweiten Impedanzeinheit (12), der dritten Impedanzeinheit (21) und der vierten Impedanzeinheit (22) mindestens eines von einem Induktor, einem Widerstand und einem Kondensator umfasst.

7. Detektionsschaltung (100) nach Anspruch 5, wobei die Stromversorgung (m1) dazu konfiguriert ist, ein Gleichstromsignal auszugeben, und wobei mindestens eine von der ersten Impedanzeinheit (11), der zweiten Impedanzeinheit (12), der dritten Impedanzeinheit (21) und der vierten Impedanzeinheit (22) mindestens eines von einem Widerstand und einem Kondensator umfasst.

## Revendications

1. Circuit de détection d'adhérence de contact de relais (100), dans lequel dans deux lignes entre une alimentation électrique (m1) et une charge (m2), un premier contact de relais (k1) est disposé dans l'une des lignes, et un second contact de relais (k2) est disposé dans l'autre ligne ;
le circuit de détection (100) comprend deux branches de détection (10, 20) ;
l'une (10) des branches de détection est connectée électriquement séparément à deux extrémités de connexion (P1 ; P2) du premier contact de relais (k1) et à une extrémité de connexion (P3) qui est du second contact de relais (k2) et qui est directement connectée à l'alimentation électrique (m1), et l'autre branche de détection (20) est connectée électriquement séparément à deux extrémités de connexion du second contact de relais (k2) et à une extrémité de connexion qui est du premier contact de relais (k1) et qui est directement connectée à l'alimentation électrique (m1) ; et
chaque branche de détection est configurée :
lorsque le premier contact de relais (k1) et le second contact de relais (k2) sont tous deux déconnectés, et que l'alimentation électrique (m1) délivre en sortie un signal, pour détecter au moins l'une d'une tension entre deux extrémités de connexion d'un contact de relais correspondant et d'une tension entre une extrémité de connexion du premier contact de relais (k1) et l'autre extrémité de connexion du second contact de relais (k2), pour déterminer, sur la base de la tension ou des tensions détectées et d'une tension de sortie de l'alimentation électrique (m1), le fait de savoir si le contact de relais correspondant est adhéré,
dans lequel dans l'une extrémité de connexion du premier contact de relais (k1) et dans l'autre extrémité de connexion du second contact de relais (k2), l'une est directement connectée à l'alimentation électrique (m1), et l'autre est directement connectée à la charge (m2).

2. Circuit de détection (100) selon la revendication 1, dans lequel la branche de détection connectée aux deux extrémités de connexion du premier contact de relais (k1) est spécifiquement configurée pour :
détecter au moins l'une d'une tension entre les deux extrémités de connexion du premier contact de relais (k1) et d'une tension entre une extrémité de connexion qui est du premier contact de relais (k1) et qui est directement connectée à la charge (m2) et une extrémité de connexion qui est du second contact de relais (k2) et qui est directement connectée à l'alimentation électrique (m1), pour déterminer, sur la base d'une tension détectée et de la tension de sortie, le fait de savoir si le premier contact de relais (k1) est adhéré.

3. Circuit de détection (100) selon la revendication 1 ou 2, dans lequel la branche de détection connectée aux deux extrémités de connexion du premier contact de relais (k1) comprend une première unité d'impédance (11), une deuxième unité d'impédance (12) et une première unité de collecte de tension (13) ;
la première unité d'impédance (11) est connectée électriquement séparément aux deux extrémités de connexion du premier contact de relais (k1), et la deuxième unité d'impédance (12) est connectée électriquement séparément à l'extrémité de connexion qui est du premier contact de relais (k1) et qui est directement connectée à la charge (m2) et à l'extrémité de connexion qui est du second contact de relais (k2) et qui est directement connectée à l'alimentation électrique (m1) ; et
au moins l'une de la première unité d'impédance (11) et de la deuxième unité d'impédance (12) est connectée électriquement à la première unité de collecte de tension (13), et la première unité de collecte de tension (13) est configurée pour collecter l'au moins l'une de la tension entre les deux extrémités de connexion du premier contact de relais (k1) et de la tension entre l'extrémité de connexion qui est du premier contact de relais (k1) et qui est directement connectée à la charge (m2) et l'extrémité de connexion qui est du second contact de relais (k2) et qui est directement connectée à l'alimentation électrique (m1).

4. Circuit de détection (100) selon la revendication 1, dans lequel la branche de détection connectée aux deux extrémités de connexion du second contact de relais (k2) est spécifiquement configurée pour :
détecter au moins l'une d'une tension entre les deux extrémités de connexion du second contact de relais (k2) et d'une tension entre une extrémité de connexion qui est du second contact de relais (k2) et qui est directement connectée à la charge (m2) et une extrémité de connexion qui est du premier contact de relais (k1) et qui est directement connectée à l'alimentation électrique (m1), pour déterminer, sur la base de la tension ou des tensions détectées et de la tension de sortie, le fait de savoir si le second contact de relais (k2) est adhéré.

5. Circuit de détection (100) selon l'une quelconque des revendications 1 à 4, dans lequel la branche de détection connectée aux deux extrémités de connexion du second contact de relais (k2) comprend une troisième unité d'impédance (21), une quatrième unité d'impédance (22) et une seconde unité de collecte de tension (23) ;
la troisième unité d'impédance (21) est connectée électriquement séparément aux deux extrémités de connexion du second contact de relais (k2), et la quatrième unité d'impédance (22) est connectée électriquement séparément à l'extrémité de connexion qui est du premier contact de relais (k1) et qui est directement connectée à l'alimentation électrique (m1) et à l'extrémité de connexion qui est du second contact de relais (k2) et qui est directement connectée à la charge (m2) ; et
au moins l'une de la troisième unité d'impédance (21) et de la quatrième unité d'impédance (22) est connectée électriquement à la seconde unité de collecte de tension (23), et la seconde unité de collecte de tension (23) est configurée pour collecter l'au moins l'une de la tension entre les deux extrémités de connexion du second contact de relais (k2) et de la tension entre l'extrémité de connexion qui est du second contact de relais (k2) et qui est directement connectée à la charge (m2) et l'extrémité de connexion qui est du premier contact de relais (k1) et qui est directement connectée à l'alimentation électrique (m1).

6. Circuit de détection (100) selon la revendication 5, dans lequel l'alimentation électrique (m1) est configurée pour délivrer en sortie un signal de courant alternatif, et au moins l'une de la première unité d'impédance (11), de la deuxième unité d'impédance (12), de la troisième unité d'impédance (21) et de la quatrième unité d'impédance (22) comprend au moins l'un d'un inducteur, d'une résistance et d'un condensateur.

7. Circuit de détection (100) selon la revendication 5, dans lequel l'alimentation électrique (m1) est configurée pour délivrer en sortie un signal de courant direct, et au moins l'une de la première unité d'impédance (11), de la deuxième unité d'impédance (12), de la troisième unité d'impédance (21) et de la quatrième unité d'impédance (22) comprend au moins l'un d'une résistance et d'un condensateur.
